# EUROPÄISCHE PATENTANMELDUNG

(11) **EP 0 756 321 A1**
(43) Veröffentlichungstag der Anmeldung: **29.01.1997**
(21) Anmeldenummer: 96111245.5
(22) Anmeldetag: 11.07.1996
(51) Int. Cl.: H01L 21/8238

(54) **Verfahren zur Herstellung komplementärer MOS-Transistoren**

(30) Priorität: 25.07.1995 DE 19527157
(71) Anmelder: SIEMENS AKTIENGESELLSCHAFT, 80333 München (DE)
(72) Erfinder: Kerber, Martin, Dr. rer. nat., 81827 München (DE)

(57) **Zusammenfassung**

Das Verfahren schlägt vor, daß nach der Bildung von Feldisolationszonen (2) in einem Siliziumsubstrat (1) und nach der Strukturierung von Gateelektroden (3) und Gateoxiden (4) für zwei komplementäre MOS-Transistoren eine erste Maske (6) mit einem Fenster (7) erzeugt wird, das einen ersten Transistorbereich definiert, in dem anschließend mittels Implantationsschritten zunächst eine Wanne (10) mit Atomen eines ersten Leitfähigkeitstyps und danach die Source- und die Drainzone (20,21) des Transistors durch eine Implantation von Atomen eines zweiten Leitfähigkeitstyps erzeugt wird. Anschließend wird die erste Maske entfernt und eine zweite Maske (30) erzeugt, die ein zweites Fenster (31) für einen zweiten Transistorbereich definiert, in dem danach eine zweite Wanne (33) durch Implantation von Atomen eines zweiten Leitfähigkeitstyps und eine Source- und eine Drainzone (40,41) für den zweiten Transistor durch Implantation von Atomen eines ersten Leitfähigkeitstyps erzeugt wird. Durch die blockweisen Implantationsschritte für jeden Transistortyp mit jeweils einer Maske kommt das Verfahren mit insgesamt vier Masken im Grundprozess aus. Die Implantationen, die durch das Polysilizium der Gates (3) und vor allem durch die Gateoxide (4) hindurch erfolgen, beeinträchtigen die Qualität vor allem der Gateoxide nicht wesentlich.

## Beschreibung

Die Erfindung betrifft ein Verfahren zur Herstellung komplementärer MOS-Transistoren, bei dem jeder der komplementären Transistoren in einer entsprechenden Wanne eines Substrats angeordnet ist und eine Source- und eine Drainzone enthält, die jeweils an eine Feldisolationszone angrenzen und einen Kanal definieren, über dem ein Gateoxid und eine Gateelektrode angeordnet sind.

Integrierte CMOS-Schaltkreise werden mit einer Vielzahl von Prozeßschritten hergestellt. Die Herstellungskosten dieser Schaltkreise werden dabei durch die Prozeßkomplexität und die physikalische Bearbeitungszeit bestimmt. Hochkomplexe Bausteine erfordern deshalb mehrere hundert einzelne Prozeßschritte bis zum fertigen Produkt und eine Vielzahl von Tagen für den Prozessdurchlauf und die Herstellung des Produkts.

Integrierte CMOS-Schaltkreise, die auf einkristallinen Siliziumscheiben hergestellt werden, erfordern üblicherweise mindestens sieben Fototechnikschritte für den Grundprozeß zur Herstellung der Schaltkreisfunktionen in dem Silizium und fünf Fototechnikschritte für zwei Metallisierungsebenen samt Passivierung. Ein typischer Prozeß umfaßt eine erste Maske für die Implantation der ersten Wanne, zu der dann selbstjustiert die komplementäre Wanne implantiert und beide in einem nachfolgenden Temperaturschritt eingetrieben werden, eine zweite Maske zur Herstellung einer Feldisolation, beispielsweise durch lokale Oxidation, eine dritte Maske zur Einstellung einer Einsatzspannung eines MOS-Transistors, wobei die Einsatzspannung eines NMOS-Transistors typischerweise ganzflächig erfolgt und die Maske dann für einen PMOS-Transistor erforderlich ist.

An die vorgenannten Schritte schließen sich eine vierte Maske für die Gatestrukturierung, eine fünfte Maske für eine niedrig dotierte Source-/Drainimplantation des NMOS-Transistors, die sogenannte LDD-Implantation, sowie eine sechste Maske für die Herstellung der hochdotierten Drain des NMOS-Transistors an. Die siebte Maske schließlich ist erforderlich für die Implantation der Drain des PMOS-Transistors.

Nach der Erzeugung ganzflächiger Isolationszwischenschichten mit Kontaktlöchern durch eine achte sind die neunte bis elfte Maske für die Metallisierung einer ersten Schicht, für die Erzeugung von Kontaktlöchern und für eine zweite Metallisierungsschicht vorgesehen. Die Metallisierungen sind üblicherweise aus Aluminium. Eine zwölfte Maske schließt sich daran an, um eine Passivierungsschicht zu erzeugen.

In Schaltkreisen, die zusätzlich noch weitere Elemente haben, beispielsweise einen Kondensator oder einen Widerstand, können weitere Masken erforderlich sein. Grundsätzlich ist es immer wünschenswert, eine möglichst geringe Anzahl von Prozeßschritten zu haben, um die Herstellungskosten und die Durchlaufzeit zu senken.

Der Erfindung liegt die Aufgabe zugrunde, ein Verfahren zur Herstellung von komplementären MOS-Transistoren der eingangs genannten Art anzugeben, das eine geringere Anzahl von Prozeßschritten erfordert.

Diese Aufgabe wird mit den Merkmalen des Patentanspruchs 1 gelöst.

Der Erfindung liegt die Erkenntnis zugrunde, daß ein erheblicher Aufwand für die Herstellung von CMOS-Schaltkreisen mit einer Verringerung der Anzahl der Maskenschritte möglich ist. Durch die laufende Verbesserung der Implantationsgeräte und durch die Skalierung von Schichtdicken ist es zwar möglich, die Wannenimplantierungen nach der Herstellung der Feldisolationszonen durchzuführen. Dadurch wird der zeitaufwendige Wanneneintreibschritt eingespart. Allerdings bleibt durch die Kombination mit einer Maske zur Einstellung der PMOS-Einsatzspannung die Gesamtzahl der Masken unverändert.

Die Erfindung sieht vor, daß die notwendige Anzahl der Fototechnikschritte bzw. die Anzahl der Masken im Grundprozeß zur Herstellung der Transistoren von sieben auf vier Masken reduziert wird. Dies ist möglich, indem die für die Realisierung der Transistoren notwendigen Implantationen in zwei hintereinanderliegenden Blöcken nach der Gatestrukturierung erfolgen, wobei für jeden Block nur eine Maske erforderlich ist. Das bedeutet, daß für den NMOS-Transistor die Erzeugung der Wanne, der Einsatzspannung der LDD-Zone und der Drainzone in einem Block mit aufeinanderfolgenden Implantationsschritten, aber mit nur einer einzigen Maske bzw. einem Fototechnikschritt erfolgt. Entsprechend wird der PMOS-Transistor mit einem einzigen weiteren fototechnischen Schritt erzeugt. Wesentlich dabei ist, daß beide Implantierungsblöcke nach der Gatestrukturierung durchgeführt werden.

Die Dicke der Gateelektrode und die Energien der Implantationsschritte sind so aufeinander abgestimmt, daß die Drain- und die LDD-Implantationen sicher durch die Gateelektrode maskiert werden. Die Reichweite der Kanalimplantation muß größer sein als die Dicke der Gateelektrode, und die Reichweite der Wannenimplanatation muß größer sein als die Summe der Feldoxiddicke und der Dicke der Gateelektrode.

Für die Reihenfolge der verschiedenen Implantationen innerhalb eines Blocks ist zu beachten, daß die Drainimplantationen vor und die LDD-Implantationen nach einer optionalen Reduktion des Spacers durch isotropes Ätzen erfolgen. Implantation von schweren Ionen wie Arsen sollte vorangestellt werden um einen Knock-on Effekt zu vermeiden.

Die Erfindung hat den Vorteil, daß die Masken für die Herstellung einer selbstjustierten Wanne, der PMOS-Einsatzspannung, der NMOS-LDD-Zone, eingespart werden können. Als Fotomasken für Implantationen bleiben lediglich eine NMOS-Maske und eine PMOS-Maske. Dementsprechend wird der Gesamtprozeß weniger komplex. Die Herstellungskosten werden gegenüber modernen CMOS-Prozessen deutlich verringert, beispielsweise um 25 %. Auch die physikalische Bearbeitungszeit wird deutlich verringert, beispielsweise von knapp über elf Tagen auf unter neun Tage.

Ausgestaltungen der Erfindung sind in Unteransprüchen gekennzeichnet.

Die Erfindung wird nachfolgend anhand eines Ausführungsbeispiels näher erläutert. Es zeigen:

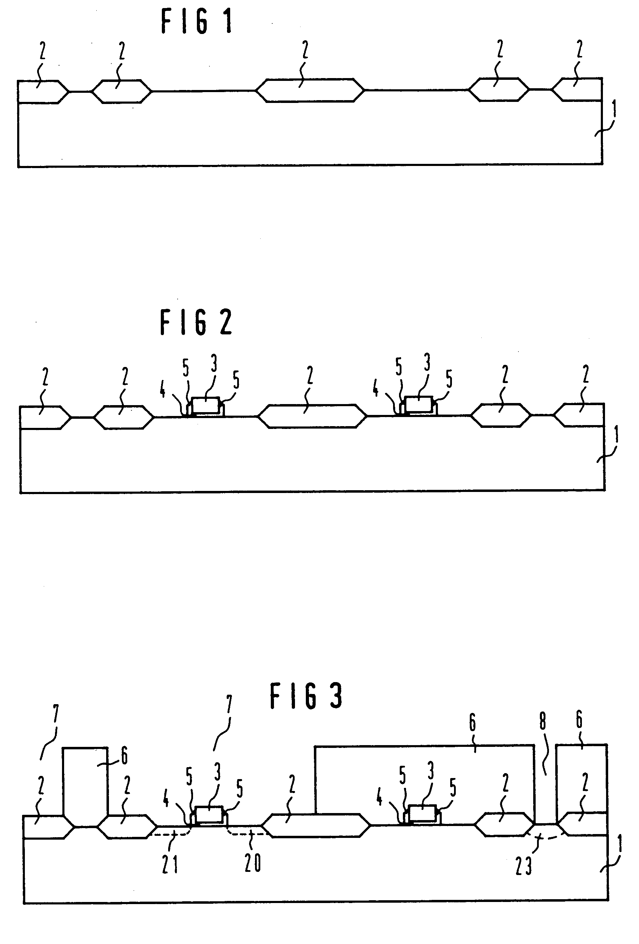

FIG 1 bis 4 schematische Querschnitte durch verschiedene Stadien des Herstellungsprozesses.

Gemäß FIG 1 beginnt der Prozeß mit der an sich bekannten Herstellung von Feldisolationszonen 2 in einem Substrat 1. Üblicherweise wird dazu zunächst eine Nitridschicht auf dem Substrat ganzflächig aufgetragen und durch eine erste Maske, die mit einer Fototechnik erzeugt wird, und einen anschließenden Ätzschritt strukturiert. Daran schließt sich die Erzeugung der Feldisolationszonen, beispielsweise als Feldoxid an. Anschließend wird die Nitridschicht entfernt. Neben der konventionellen Technik mit Hilfe einer lokalen Oxidation (LOCOS) kann ein Oxid aus der Gasphase chemisch abgeschieden und strukturiert werden oder man erzeugt die Isolationszonen durch anisotropes Ätzen und Auffüllen mit Oxid (Shallow Trench Isolation). Man erhält die Anordnung gemäß FIG 1.

Es schließt sich die Erzeugung eines Gateoxids von typisch 15 nm Dicke sowie die Abscheidung einer Siliziumschicht von beispielsweise 200 nm an. Eine mit einer zweiten Fototechnik erzeugten zweite Maske in Verbindung mit einem weiteren Ätzschritt führt zu einer strukturierten Gateelektrode 3, die durch das Gateoxid 4 vom Substrat isoliert ist.

An die Strukturierung der Gateelektrode schließt sich typischerweise ein Oxidationsschritt an, mit dem eine Oxidschicht von 10 nm ganzflächig erzeugt wird. Darüber wird mit Hilfe eines CVD-Verfahrens (chemische Abscheidung beispielsweise durch Pyrolyse von Tetraethylorthosilan bei reduziertem Druck (low-pressure-CVD) eine Isolationsschicht konform abgeschieden, die anschließend anisotrop vollständig oder teilweise rückgeätzt wird, so daß zumindest seitliche Isolationsstege 5 neben der Gatelektrode stehen bleiben. Danach werden mit einer ersten Lackmaske 6 die NMOS-Transistoren definiert.

Mit einer tiefen Implantation, d.h. mit einer hohen Implantationsenergie, wird eine retrograde p-Wanne 10 erzeugt, wie sie beispielsweise in dem Buch D. Widmann et al.: Technologie hochintegrierter Schaltungen, Springer-Verlag, 1988, Seite 284, beschrieben ist. Bei einer üblichen Dicke der Feldisolation von etwa 400 nm ist ein typischer Energiebereich von 250 keV möglich. Die typische Ionendosis an Bor-Atomen liegt bei etwa 10¹³ Atomen.

Die Implantationen für den NMOS-Transistor erfolgen in diesem Ausführungsbeispiel - zur besseren Illustration - in umgekehrter Reihenfolge zur Implantationsfolge in einem konventionellen CMOS-Prozeß, können aber auch in konventioneller Reihenfolge erfolgen.

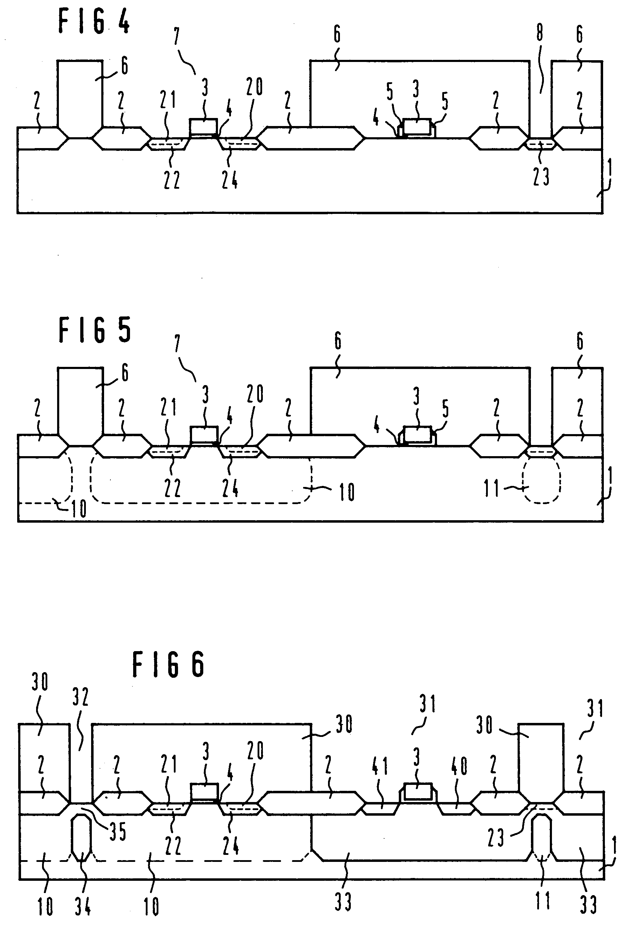

Als erste Implantation wird die NMOS-Drainimplantation von beispielsweise: Arsen, 40 keV, 5.0 · 10¹⁵ Atome durchgeführt. Die Energie darf nur so groß sein, daß sie durch die Gateelektrode im Kanalbereich und den Spacer im LDD-Bereich maskiert wird, FIG 3. Dann wird durch eine isotrope Ätzung der Spacer entsprechend der Patentanmeldung P 44 15 568.9 entfernt und eine LDD-Implantation von beispielsweise: Phosphor, 40 keV, 4 · 10¹³ Atome implantiert, FIG 4).

Im Anschluß daran wird soweit erforderlich und vorgesehen, eine Kanalimplantation von beispielsweise Bor, 60 keV 4 · 10¹² Atome, durchgeführt, deren Energie so gewählt ist, daß die Reichweite größer, aber nicht viel größer als die Dicke der Gateelektrode ist. Schließlich wird eine tiefe Implantation durchgeführt, die die p-Wanne erzeugt, FIG 5.

Gleichzeitig mit den Implantationen für den NMOS-Transistor werden die Kontakte der komplementären Wanne erzeugt. Dazu werden die vorzugsweise kleinen, quadratischen Kontaktbereiche 8 in der NMOS-Maske freigelegt. Durch die NMOS-Drainimplantation und die NMOS-LDD-Implantation wird im Bereich der Oberfläche ein stark dotiertes Gebiet 23 erzeugt, das den gleichen Leitungstyp wie die komplementäre Wanne aufweist. Die (in diesem Anwendungsbeispiel) nachfolgende tiefe Wannenimplantation erzeugt unterhalb des Kontaktgebietes 23 einen kleinen Bereich, in dem die komplementäre Wanne umdotiert wird. Dieser behindert die Funktion des Substratkontaktes aber nur in vertretbarem Ausmaß, solange dieser nicht an die Halbleiteroberfläche reicht. Durch die vorzugsweise kleinen Abmessungen der Kontaktbereiche 8 und die laterale Streuung (Straggling) der tiefen Wannenimplantation ist die mittlere Dotierstoffkonzentration des - an sich unerwünschten - Wannenpfropfens (Wannenplug) deutlich kleiner als die der umgebenden (komplementären) Wanne, so daß sie nicht bis an die Halbleiteroberfläche reichen. So wie die Kontaktbereiche für die komplementären Wannen geöffnet werden, müssen analog die Kontaktbereiche der lokalen Wanne abgedeckt bleiben. In einer speziellen Ausführungsform kann die isotrope Entfernung des Spacers und die LDD-Implantation durch eine Implantation mit schrägem Einfallswinkel, beispielsweise Phosphor, 60 keV, 4 · 10¹³ Atome unter 60° geneigt gegen die Halbleiteroberfläche, implantiert werden.

Anschließend wird die Maske 6 entfernt und eine zweite Maske 30 erzeugt, die die PMOS-Transistoren definiert. In entsprechender Weise werden die Source-/Drain-Zonen 40 und 41 durch die Implantation von Borionen bei typischerweise 10 keV, 5 · 10¹⁵ Atome oder BF₂ bei 15 keV, 5 · 10¹⁵ Atome hergestellt. Üblicherweise werden PMOS-Transistoren ohne entsprechende LDD-Bereiche ausgeführt, so daß sie in diesem Anwendungsbeispiel entfällt. Sollte eine solche Implantation, beispielsweise für Anwendungen in Analog-Schaltungen notwendig sein, kann die entsprechende Prozeßsequenz wie beim NMOS-Transistor durchgeführt werden.

Es folgt die Implantation für den PMOS-Kanalbereich beispielsweise Bor, 60 keV, 3.0 · 10¹² Atome sowie eine Implantation zur Verbesserung der Transistor-Punch-Festigkeit beispielsweise Phosphor, 180 keV, 2.0 · 10¹² Atome.

Schließlich wird die n-Wanne implantiert (Phosphor, 500 keV, 10¹³ Atome).

Durch Freilegen der komplementären Kontaktbereiche entsteht analog ein Kontakt im Bereich der Halbleiteroberfläche. Der gleichzeitige Wannenplug stört diese Funktion in vertretbarem Ausmaß.

Anschließend wird die zweite Transistormaske 30 entfernt und der Herstellprozeß in an sich bekannter Weise fortgeführt, beispielsweise durch Aufbringen einer Isolierschicht wie BPSG (Bor-Phosphor-Silicat-Glas), das verflossen wird, um die Oberfläche einzuebenen. Mit Hilfe von Kontaktlöchern werden die Transistoranschlußzonen mit nachfolgend aufzubringenden Metallisierungsschichten kontaktiert.

Dadurch daß die Erfindung für die Herstellung des NMOS-Transistors und des PMOS-Transistors jeweils nur eine Maske erfordert, mit deren Hilfe sämtliche Implantierungen durchgeführt werden, können die bisher üblichen Fotoschritte für eine selbstjustierte Wanne, für die PMOS-Einsatzspannung für das LDD-Gebiet der NMOS-Transistoren eingespart werden.

Überraschend zeigt sich bei einem erfindungsgemäßen Verfahren, daß die bei jeder der beiden Transistormasken vorgesehenen Implantationen, die durch das Polysilizium des Gates 3 und vor allem durch das Gateoxid 4 hindurch erfolgen, die Qualität vor allem des Gateoxids nicht wesentlich beeinträchtigt wird, so daß ausreichend zuverlässige Transistoren hergestellt werden können. In Versuchen konnte keine nennenwerte Verschlechterung der intrinsischen Durchbruchsfestigkeit und keine Zunahme der extrinsischen Defektdichte mit den genannten typischen Implantationsenergien festgestellt werden.

Die Frage des Substrat- bzw. Wannenkontaktes ist bei der Erfindung gemäß FIG 4 dadurch gelöst, daß die mit Hilfe der Öffnungen 8 und 32 gebildeten Wannenplugs 11 und 34 in der Tiefe des Substrats liegen und daß oberhalb dieser Plugs hochdotierte Zonen 23 und 35 sind, die nahe der Halbleiteroberfläche zwischen den Wannenplugs entgegengesetzter Dotierung und einem zugehörigen Feldisolationsgebiet eine Verbindung zwischen der Wanne 33 und dem Anschluß 23 einerseits und der Wanne 10 sowie dem Anschluß 35 andererseits herstellen. Der Wannenkontakt entsteht dabei durch die unterschiedliche in der Tiefe liegende räumliche Dotierstoffverteilung der Implantationen Es zeigt sich, daß die Kontaktierung der Wannen mit Hilfe der geschilderten Zonen 23 und 35 ausreichend gut ist.

Unter wirtschaftlichen Aspekten zeigt sich, daß durch die gegenüber Standardprozessen deutlich geringere Anzahl der Masken sowie auch durch die schnelleren physikalischen Durchlaufzeiten eine erhebliche Einsparung bei der Herstellung der komplementären MOS-Transistoren möglich ist.

## Patentansprüche

1. Verfahren zur Herstellung komplementärer MOS-Transistoren in einem Substrat, bei dem jeder der komplementären Transistoren in einer entsprechenden Wanne angeordnet ist und eine Source- und eine Drainzone enthält, die jeweils an eine Feldisolationszone angrenzen und einen Kanal definieren, über dem ein Gateoxid und eine Gateelektrode angeordnet sind,
**gekennzeichnet** durch folgende Schritte:
a) für jeden der komplementären Transistoren werden die Feldisolationszonen (2), das Gateoxid (4) und die Gateelektrode (3) hergestellt,
b) mittels einer ersten Maske wird ein erstes Fenster (7) für einen ersten Transistor eines ersten Leitfähigkeittyps definiert,
c) mittels der ersten Maske wird eine erste Wanne (10) durch tiefe Implantation von Ionen eines ersten Leitfähigkeittyps erzeugt,
d) mittels der ersten Maske werden hochdotierte Zonen (20, 21, 23) durch flache Implantation von Atomen eines zweiten Leitfähigkeittyps an der Substratoberfläche erzeugt,
e) die erste Maske wird entfernt und eine zweite Maske (30) erzeugt, die ein zweites Fenster (31) für einen zweiten Transistor eines zweiten Leitfähigkeittyps definiert,
f) mittels der zweiten Maske (30) wird eine zweite Wanne (33, 34) durch tiefe Implantation von Atomen eines zweiten Leitfähigkeittyps erzeugt,
g) mittels der zweiten Maske werden hochdotierte Zonen (40, 41, 35) durch flache Implantation von Atomen eines ersten Leitfähigkeittyps erzeugt, und
h) die zweite Maske wird entfernt.

2. Verfahren nach Anspruch 1,
**dadurch gekennzeichnet,** daß
die Feldisolationszonen (2) durch lokale Oxidation oder durch Strukturieren eines mit Hilfe eines CVD-Verfahrens erzeugten Oxids oder durch Ätzen flächer Gräben im Isolationsbereich und Auffüllen mit einem Oxid hergestellt werden.

3. Verfahren nach Anspruch 1 oder 2,
**dadurch gekennzeichnet,** daß
nach der Strukturierung der Gateelektrode (3) seitliche Isolationsstege (5) durch konforme Abscheidung und anisotropes Rückätzen einer Oxidschicht hergestellt werden.

4. Verfahren nach Anspruch 3,
**dadurch gekennzeichnet,** daß
die Isolationsstege (5) jeweils nach der Implantation der hochdotierten Zonen des ersten bzw. zweiten Leitfähigkeitstyps (20, 21, 23; 40, 41, 35) isotrop geätzt werden und eine weitere Implantation von Atomen desselben Leitungstyps wie die der jeweiligen hochdotierten Zone mit Hilfe der jeweiligen ersten bzw. zweiten Maske zur Erzeugung von niedrigdotierten Source-/Drain-Zonen erfolgt.

5. Verfahren nach Anspruch 3,
**dadurch gekennzeichnet,** daß
mit der ersten und der zweiten Maske jeweils niedrigdotierte Source-/Drain-Zonen (24, 25; 42, 43) durch schräge Implantation von Atomen vom Leitungstyp der angrenzenden hochdotierten Zonen (20, 21, 40, 41) erzeugt werden.

6. Verfahren nach einem der Ansprüche 1 bis 5,
**dadurch gekennzeichnet,** daß
jede der Wannen als retrograde Wanne erzeugt wird.

7. Verfahren nach einem der Ansprüche 1 bis 6,
**dadurch gekennzeichnet,** daß
nach jeder Wannenimplantation eine flache Implantation von Atomen desselben Leitfähigkeitstyps wie die Wannendotierung zur Einstellung der Transistoreinsatzspannung erfolgt.

8. Verfahren nach einem der Ansprüche 1 bis 7,
**dadurch gekennzeichnet,** daß
das erste und das zweite Fenster bis über die den Transistorzonen benachbarten Feldisolationsbereiche reicht.

9. Verfahren nach einem der Ansprüche 1 bis 8,
**dadurch gekennzeichnet,** daß
jede der Wannen durch eine hochdotierte, an der Substratoberfläche erzeugte Zone des gleichen Leitfähigkeitstyps kontaktierbar ist, die zwischen zwei Feldisolationsgebieten mit Hilfe einer in der ersten bzw. zweiten Maske vorgesehenen Öffnung (8, 32) im gleichen Schritt erzeugt ist, wie die hochdotierten Zonen (20, 21; 40, 41) der Transistoren.
